# EUROPEAN PATENT SPECIFICATION

(11) **EP 4 212 893 B1**
(45) Date of publication and mention of the grant of the patent: **11.06.2025**
(21) Application number: 21866442.3
(22) Date of filing: 06.08.2021
(51) Int. Cl.: G01R 31/08, G01R 31/12

(54) **PARTIAL DISCHARGE MONITORING DEVICE AND PARTIAL DISCHARGE MONITORING METHOD**
TEILENTLADUNGSÜBERWACHUNGSVORRICHTUNG UND TEILENTLADUNGSÜBERWACHUNGSVERFAHREN
DISPOSITIF ET PROCÉDÉ DE SURVEILLANCE DE DÉCHARGE PARTIELLE

(30) Priority: 08.09.2020 JP 2020150801
(43) Date of publication of application: 19.07.2023
(73) Proprietor: JFE Steel Corporation, Tokyo 100-0011 (JP); JFE Advantech Co. Ltd., Nishinomiya-shi, Hyogo 663-8202 (JP)
(72) Inventor: KUWADA, Yasunori, Tokyo 100-0011 (JP); MORI, Toshio, Tokyo 100-0011 (JP); ODA, Masahiro, Nishinomiya-shi, Hyogo 663-8202 (JP); TAMURA, Yuui, Nishinomiya-shi, Hyogo 663-8202 (JP); SUENAGA, Kiyoka, Nishinomiya-shi, Hyogo 663-8202 (JP)
(74) Representative: Haseltine Lake Kempner LLP
(86) International application number: PCT/JP2021/029428
(87) International publication number: WO 2022/054482

(56) References cited:
- JP-A- 2001 249 157
- JP-A- 2004 239 735
- JP-A- 2016 061 733
- JP-A- 2018 151 345
- JP-A- 2020 101 488
- JP-A- 2020 101 488
- JP-A- H 085 698
- JP-A- H 085 698
- JP-A- H0 749 362
- JP-A- H11 352 179
- JP-B2- 5 092 878
- US-A1- 2010 241 372
- QI WANG ET AL: "Suppression of pulse interference in partial discharge measurement based on phase correlation and waveform characteristics", 2014 INTERNATIONAL CONFERENCE ON POWER SYSTEM TECHNOLOGY, IEEE, 20 October 2014 (2014-10-20), pages 1338 - 1341, XP032711687, DOI: 10.1109/POWERCON.2014.6993655

## Description

### Technical Field

The present invention relates to the technology to prevent alternating-current electrical equipment owned privately or owned by a company from breaking down due to adverse environment, deterioration, or the like. Further, the present invention relates to the technology to evaluate the occurrence state of partial discharge in the electrical equipment.

Particularly, the present invention can be preferably applied to electrical equipment such as a switchboard of 400 V or more (particularly, a switchboard of 3 kV or more), a transformer, or an electric cable related to them.

### Background Art

Partial discharge is a phenomenon to cause partial bridging inside an insulator near a conductive material. The partial discharge appears as a precursory phenomenon of an accident in a high-voltage isolation circuit. Accordingly, by executing evaluation or the like on the occurrence state of partial discharge, a deterioration in an insulation material can be detected in advance. By taking measures such as repair based on the detection, the accident can be prevented beforehand.

Accordingly, in an electric power facility during operation, for example, a monitoring technology for the electric power facility by which an abnormality such as insulation deterioration can be detected and diagnosed by detecting partial discharge is demanded.

In terms of alternating-current electrical equipment, the fact that partial discharge occurs with a powerline period or its double periodicity has been widely known. Then, partial discharge is detected by extracting the periodicity from a waveform measured by a sensor that can detect partial discharge. For example, a method using a discharge component ratio calculated by the following equation to detect partial discharge is known. The discharge component ratio in the following equation can be obtained from a power supply frequency component (an fv component) included in a signal waveform and a double component of the power supply frequency(a 2fv component). Discharge component ratio [%] = {(fv component + 2fv component) / all data} × 100

Here, the fv component or the 2fv component can be found by performing frequency analysis on a waveform constituted by only partial discharge signals, as component strength of the power supply frequency or its double frequency. Note that only the 2fv component may be used or an integral multiple component equal to or more than three times the power supply frequency may be added for the calculation of the discharge component ratio.

In the meantime, under the environment where the alternating-current electrical equipment works, disturbance noise such as vibration or magnetostrictive noise that excites electrically may occur as well as partial discharge. The disturbance noise may have the powerline period or the periodicity of an integral multiple of the powerline period. Accordingly, even when the periodicity of a signal received by a sensor for partial discharge just coincides with the powerline period or the integral multiple of the powerline period, disturbance noise might be mistakenly detected as the occurrence of partial discharge.

In view of this, for example, PTL 1 discloses the technology to detect sound caused by the occurrence of partial discharge and to use the fact that disturbance noise having the powerline period strictly occurs every powerline period, whereas a signal caused by partial discharge occurs in an uneven occurrence timing. More specifically, in PTL 1, a correlation coefficient between a signal waveform of a high frequency component extracted from a detection signal and a signal waveform delaying from the signal waveform of the high frequency component by one period of the power supply frequency is calculated. PTL 1 discloses an electric discharge detection/identification device configured to detect/identify the discharge sound from the correlation coefficient and a double-frequency component of the power supply frequency.

### Citation List

### Patent Literature

PTL 1: JP 5092878 B
Reference may also be made to:
Qi Wang et al. "Suppression of Pulse Interference in Partial Discharge Measurement based on Phase Correlation and Waveform Characteristics," 2014 International Conference on Power System Technology (POWERCON 2014), Chengdu, 20-22 Oct. 2014, which studies the phase correlation of some types of typical partial discharge pulses and their characteristics in time domain and frequency domain;
JP 5092878 (B2) which relates to an electric discharge detection/identification device;
JP H085698 (A) which relates to a method and apparatus for detecting partial discharge; and
JP 2020101488 (A) which relates to a partial discharge detector and partial discharge detection method.

### Summary of Invention

### Technical Problem

However, in the method described in PTL 1, the correlation of the whole waveform obtained by one measurement is considered. Accordingly, in PTL 1, even when a signal by partial discharge to be detected and a disturbance noise signal to be excluded are superposed, both the signals in the waveform are not distinguished or separated from each other. Accordingly, in PTL 1, for example, in a case where a partial discharge signal is small in comparison with a disturbance noise signal on which the partial discharge signal is superposed, the partial discharge signal might be missed. Further, in PTL 1, whether or not partial discharge occurs can be determined when disturbance noise is superposed, but the degree and the occurrence frequency of partial discharge cannot be evaluated.

The present invention is accomplished in view of the above points, and an object of the present invention is to enable evaluation on the degree and the occurrence frequency of partial discharge even under disturbance noise, by distinguishing or separating both signals in the waveform obtained by one measurement from each other. Further, an object of the present invention is to improve the accuracy of determination on whether or not partial discharge occurs and the accuracy of monitoring of electrical equipment by detection of partial discharge.

### Solution to Problem

The inventors found the following findings.

That is, the inventors considered using the fact that disturbance noise having the powerline period strictly occurs every powerline period, whereas a signal caused by partial discharge occurs in an uneven occurrence timing, as described in PTL 1. The inventors obtained such a finding that, by using this fact, the accuracy of extraction of a partial discharge signal could be improved by performing determination on individual signals instead of the entire of one measurement. More specifically, the inventors found that, when the difference between a detected signal and a signal shifted from the detected signal by an integer period was taken, a disturbance noise signal strictly synchronous with the powerline period had a relatively small amplitude as compared with a partial discharge signal. Based on the finding, the inventors achieved the present invention which is defined by the appended claims. The invention provides partial discharge monitoring devices according to claims 1 and 4, and corresponding methods according to claims 8 and 9.

### Advantageous Effects of Invention

With the aspects of the present invention, a disturbance noise component synchronous with the powerline period can be largely removed from electrical signals detected by the sensor, and therefore, the accuracy of extraction of a partial discharge signal improves. As a result, with the aspects of the present invention, the accuracy of monitoring of the electrical equipment based on the occurrence of partial discharge is improved more. Further, even in a case where disturbance noise is superposed, it is possible to evaluate the degree of partial discharge and the occurrence frequency of partial discharge.

### Brief Description of Drawings

FIG. 1 is a view illustrating a configuration of a partial discharge monitoring device according to an embodiment based on the present invention;
FIG. 2 is a view illustrating an example of a detected waveform in a case where partial discharge occurs;
FIG. 3 is a view illustrating an example of a correlation diagram of the detected waveform;
FIG. 4 illustrates an example of the frequency distribution of the absolute values of amplitudes in a one-period differential waveform of the detected waveform;
FIG. 5 is a view illustrating an example of the frequency distribution in the one-period differential waveform of the detected waveform;
FIG. 6 is a view illustrating examples of the detected waveform and a waveform (a partial discharge signal) obtained by extracting only the partial discharge signal included in the detected waveform;
FIG. 7 is a view illustrating examples of the detected waveform and the waveform (the partial discharge signal) obtained by extracting only the partial discharge signal included in the detected waveform;
FIG. 8 illustrates the frequency distribution of a detected waveform to describe Modification 2; and
FIG. 9 is a view illustrating regions (a hatching part) in where included data is considered as a partial discharge signal in Modification 2.

### Description of Embodiments

The inventors found that, in data of a differential waveform, data of a disturbance noise component synchronous with a powerline period, appearing near zero, could be approximated to a normal distribution with the average of zero. Note that the data of the differential waveform is data of a differential waveform constituted by the difference in amplitude between a waveform obtained by performing a detection process on measured signals and signal shifted from the detection-processed waveform by an integer period of a power supply frequency. Based on the finding, in the following embodiment, in the differential waveform, data of a part near zero, having a small amplitude, is approximated as a normal distribution. Hereby, a threshold between disturbance noise strictly synchronous with the powerline period and a partial discharge signal is determined. By extracting time at which an amplitude exceeds the threshold, only a signal caused by partial discharge is extracted from a measured signal waveform or a detection-processed waveform of the measured signal waveform.

Here, in the present embodiment, the discriminability of a disturbance noise signal is raised by comparing measured signal with the signal waveform shifted by an integer period. In this viewpoint, the present embodiment is the same as PTL 1. However, in the present embodiment, separation identification between the disturbance noise signal synchronous with the powerline period and the partial discharge signal is performed on individual data included in an observation waveform. As a result, in the present embodiment, even in a case where powerline-period synchronous noise is mixed with the partial discharge signal, only the partial discharge signal can be extracted. Hereby, the present embodiment improves the accuracy of monitoring of a partial discharge occurrence state.

The following describes the embodiment of the invention more specifically, with reference to the drawings. Note that the present invention can be embodied in various forms and is not limited to the embodiment described in the present specification. The present embodiment is provided with an intention to allow a person skilled in the art to sufficiently understand the scope of the invention, by sufficiently disclosing the specification.

### (Configuration)

### <Partial discharge monitoring device 10>

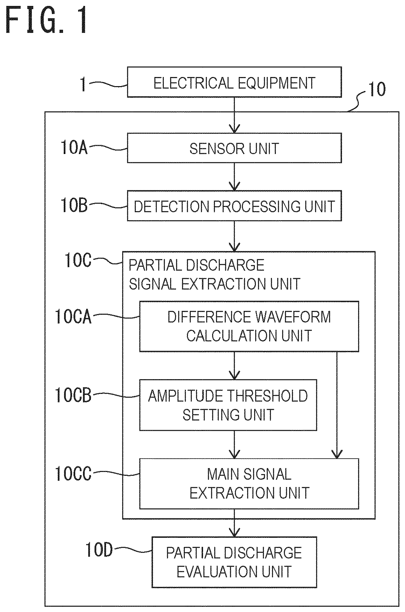

As illustrated in FIG. 1, a partial discharge monitoring device 10 of the present embodiment includes a sensor unit 10A, a detection processing unit 10B, a partial discharge signal extraction unit 10C, and a partial discharge evaluation unit 10D.

Note that the partial discharge monitoring device 10 may be operated continuously or intermittently for monitoring of the occurrence of partial discharge.

### <Sensor unit 10A>

The sensor unit 10A is a measuring device that can detect, as an electrical signal, a physical quantity to be caused when partial discharge occurs in electrical equipment 1 under inspection.

In the present embodiment, the sensor unit 10A is a TEV sensor configured to detect a TEV (Transient Earth Voltage) change to be caused in the electrical equipment 1 under inspection. The sensor unit 10A is not limited to the TEV sensor. The sensor unit 10A may be an electromagnetic wave sensor configured to detect an electromagnetic wave or an ultrasonic sensor configured to detect an ultrasonic wave to be generated with partial discharge from the electrical equipment 1 under inspection. Further, the sensor unit 10A may be an HFCT (a high frequency current transformer), an AE sensor (an acoustic sensor), or the like.

There are no problems in particular, provided that the sensor unit 10A is a measuring device that can detect, as an electrical signal, a physical quantity related to partial discharge emitted from the electrical equipment 1 under inspection.

The sensor unit 10A continuously measures, as an electrical signal, the physical quantity to be caused when partial discharge occurs.

### <Detection processing unit 10B>

The detection processing unit 10B removes noise components with low frequencies by a high pass filter, for example, from electrical signals continuously detected by the sensor unit 10A.

Further, the detection processing unit 10B executes a detection process by a peak hold function to hold a maximum value for a given period of time and executes a digitizing process by AD conversion at a sampling frequency set in advance. Note that the detection processing unit 10B does not need to use all data detected by the sensor unit 10A.

### <Partial discharge signal extraction unit 10C>

As for detection processing signals processed in the detection processing unit 10B, based on a signal measured in each time and a signal shifted from the each time by m periods (m: an integer equal to or more than 1) of the power supply frequency of the electrical equipment 1, the partial discharge signal extraction unit 10C determines whether or not partial discharge occurs in the each time. Then, the partial discharge signal extraction unit 10C executes a process of extracting a partial discharge signal from the electrical signals or the detection processing signals.

The determination on whether or not partial discharge occurs is performed based on the difference in amplitude between the signal measured in each time and the signal shifted from the each time by m periods (m: an integer equal to or more than 1) of the power supply frequency of the electrical equipment 1.

The partial discharge signal extraction unit 10C of the present embodiment includes a differential waveform calculation unit 10CA, an amplitude threshold setting unit 10CB, and a main signal extraction unit 10CC.

### <Differential waveform calculation unit 10CA>

The differential waveform calculation unit 10CA executes a process of calculating a differential waveform based on a signal waveform (the detection processing signals) processed by the detection processing unit 10B. The differential waveform is constituted by the difference in amplitude between a detection processing signal and a signal shifted from the detection processing signal by m periods (m: an integer equal to or more than 1) of the power supply frequency of the electrical equipment 1.

By this process, the amplitude of a signal strictly synchronous with the powerline period becomes zero or small.

The differential waveform calculation unit 10CA of the present embodiment calculates a differential waveform constituted by the difference in amplitude between the signal waveform processed by the detection processing unit 10B and a signal waveform obtained by shifting the signal waveform by one period of the power supply frequency.

Here, the power supply frequency of the electrical equipment 1 is normally 60 Hz or 50 Hz, but the present invention is not limited to this.

### <Amplitude threshold setting unit 10CB>

In the present embodiment, it is assumed that, in the amplitude distribution of data of the differential waveform calculated by the differential waveform calculation unit 10CA, a distribution near zero follows a normal distribution with the average of zero. The amplitude threshold setting unit 10CB finds a standard deviation σ in the normal distribution and sets an amplitude threshold TA based on the standard deviation σ.

What percentage of one normal distribution points at which the difference from an average value is equal to or less than z times of the standard deviation occupy can be known by use of a standard normal distribution list or the like. For example, the points at which the difference from the average value is equal to or less than half of the standard deviation occupy 38.3% of the one normal distribution.

By use of this, the following process is performed, for example. That is, in the differential waveform calculated by the differential waveform calculation unit 10CA, an amplitude value below which just 38.3% of the absolute values of amplitudes of the differential waveform from the lowest are included is found. By doubling the amplitude value, the standard deviation σ of the normal distribution that the distribution near zero follows in the amplitude distribution of the data of the differential waveform calculated by the differential waveform calculation unit 10CA can be found.

In the present embodiment, the value of z is increased from 0.1 by 0.1 to sequentially estimate the standard deviation. When z is sufficiently small, it is confirmed that each estimated standard deviation σ takes a fixed value, and the value is taken as the standard deviation σ of the normal distribution that the distribution near the amplitude of zero in the differential waveform follows.

Here, z is used to find the standard deviation σ of the normal distribution that the distribution near the amplitude of zero in the differential waveform follows. As the value of z, one value may be selected from 0 to 1 to perform the above calculation. In this case, z should be preferably set to 0.5.

The amplitude threshold TA is set to a value obtained by multiplying the standard deviation σ by a scale factor X, for example. The scale factor X is preferably a value selected from a range equal to or more than 2 but equal to or less than 4. More preferably, the scale factor X is set to 3 or around 3 (e.g., equal to or more than 2.5 but equal to or less than 3.5).

The present embodiment deals with a case where the amplitude threshold TA is set to 3σ.

### <Main signal extraction unit 10CC>

The main signal extraction unit 10CC extracts time at which the amplitude exceeds the amplitude threshold TA in the differential waveform calculated by the differential waveform calculation unit 10CA. The main signal extraction unit 10CC determines that, among the detection processing signals, a signal corresponding to the time thus extracted is a partial discharge signal, and signals other than the signal are signals caused by disturbance noise. Hereby, the main signal extraction unit 10CC executes a process of extracting only a partial discharge signal waveform by replacing the signals caused by disturbance noise with zero.

### <Partial discharge evaluation unit 10D>

Based on the partial discharge signals extracted by the main signal extraction unit 10CC, the partial discharge evaluation unit 10D executes a process of evaluating whether or not partial discharge occurs in the electrical equipment 1 under inspection or the degree of the occurrence of partial discharge.

The partial discharge evaluation unit 10D evaluates the occurrence state of partial discharge in the electrical equipment 1 based on a PD-pulse percentage (%), for example. The PD-pulse percentage (%) represents a percentage of signals other than zero in the partial discharge signal waveform extracted by the main signal extraction unit 10CC. In the evaluation, as the PD-pulse percentage is larger, it is diagnosed that partial discharge is occurring frequently, for example. When the PD-pulse percentage is equal to or more than a boundary value set in advance, it is determined that the electrical equipment 1 requires maintenance.

When the PD-pulse percentage is equal to or more than a few to 10 %, for example, it can be determined that partial discharge surely occurs.

It is preferable that a determination threshold PT for the PD-pulse percentage be set based on the following (a), for example. In a case where the scale factor X is set to a range smaller than 2, it is preferable to also consider the following (b) and to set the determination threshold PT to a larger value out of the following values. (a) Determination Threshold PT [%] of PD-pulse Percentage = (Power Supply Frequency [Hz] / Sampling Frequency [Hz]) × 100

This value is a PD-pulse percentage when one partial discharge (one data) occurs every one period of the power supply. For example, in a case where the power supply frequency is 60 Hz and the sampling frequency is 2.56 kHz, the PD-pulse percentage is 2.34%.
(b) A probability q of an error that can occur when no partial discharge occurs, that is, when the frequency distribution of a waveform obtained by the detection process follows the normal distribution.

Further, the partial discharge evaluation unit 10D may monitor the occurrence state of partial discharge in the electrical equipment 1, for example, by a process, conventionally executed, of extracting power supply periodicity from the partial discharge signal waveform extracted by the main signal extraction unit 10CC.

In this case, as an index indicative of the power supply periodicity, a discharge component ratio may be used, for example.

Further, a monitoring process may be executed on the electrical equipment 1 under inspection, for example, depending on an increasing state of the discharge component ratio to a plurality of PD-pulse percentages measured over time or the partial discharge signal waveform extracted by the main signal extraction unit 10CC.

### <As for sampling amount of measurement data for evaluation>

The measurement time in the sensor unit 10A to be used for evaluation on one partial discharge is set to be equal to or more than three times of the powerline period, for example. Preferably, it is desirable that the measurement time be equal to or more than 10 times of the powerline period to see the periodicity of the partial discharge signal after the extraction.

Further, it is preferable that the waveform data after the detection process to be used for the evaluation on one partial discharge include at least six or more points. It is more preferable that the waveform data after the detection process include 400 or more points. The data amount of the waveform data does not have any upper limit.

For example, in a case where there are 400 points in the length corresponding to 10 powerline periods, there are 40 points per one period (e.g., one point per 0.4 to 0.5ms), and therefore, it is possible to sufficiently observe fluctuations in a discharge signal. Further, for example, for about 100 powerline periods, about 40 points of data per one period are obtained.

Here, the amplitude threshold TA is assumed 3σ. In this case, when there are 400 or more points to be generated in accordance with a normal distribution N (µ, σ) where µ indicates an average and σ indicates a standard deviation, it can be expected that there is one or more points separated from the average by 3σ or more. On this account, it can be expected that σ can be estimated with accuracy.

### <As for preferable range of scale factor X set in advance>

Herein, it is assumed that there is data corresponding to three periods or more in terms of a powerline period τ.

At this time, in terms of a measured value f(t) in time t after the detection process, when a difference f(t) - f(t-τ) from one pervious period and a difference f(t) - f(t+τ) from one subsequent period are both equal to or more than the amplitude threshold TA, the measure value f(t) is estimated to be a partial discharge signal.

Further, the following assumes a case where no partial discharge occurs in any of time t-τ, time t, and time t+τ. Further, respective probabilities of the difference f(t) - f(t-τ) and the difference f(t) - f(t+τ) being accidentally equal to or more than the amplitude threshold TA are taken as p. In this case, with a probability p² (= q), a signal f(t) that is not partial discharge is regarded as partial discharge.

The scale factor X is used to determine the probability p where the difference between signals that are not partial discharge is equal to or more than the amplitude threshold TA.

In view of this, the following considers the range of the scale factor X.

In terms of given σ, the probability p that a signal following a normal distribution N (0, σ²) with the average of zero falls within a range equal to or more than nσ, and p² at that time are as described in Table 1.

**[Table 1]**

| nσ | p | p²(= q) |
|---|---|---|
| 1σ | 0.3174 | 0.1007 |
| 2σ | 0.0456 | 0.002079 |
| 3σ | 0.0026 | 0.00000676 |
| 4σ | 0.00006334 | 4.0119556*10⁻⁹ |

As can be seen from Table 1, in the case that no equals to 1σ, p² = 10% is obtained. When errors up to 10% are allowable, the scale factor X may be set to 1. However, the errors up to 10% seem to be insufficient as noise removal.

In the meantime, errors at 2σ are equal to or less than 0.2%, and therefore, when the scale factor X is set to be equal to or more than 2, noise can be sufficiently removed. On the other hand, when n in nσ is raised too high, the possibility to overlook a partial discharge signal increases.

Thus, it is preferable that the scale factor X fall within a range equal to or more than 2 but equal to or less than 4.

### (Operation and so on)

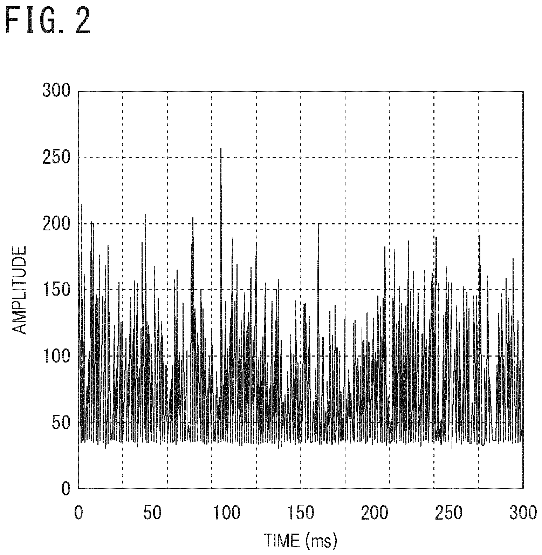

In terms of a measured waveform measured by the sensor unit 10A, a waveform after the detection process in the detection processing unit 10B is a waveform illustrated in FIG. 2, for example. In FIG. 2, the horizontal axis indicates time, and the vertical axis indicates amplitude.

The measured waveform illustrated in FIG. 2 is an example in a case where the measured waveform includes data of partial discharge.

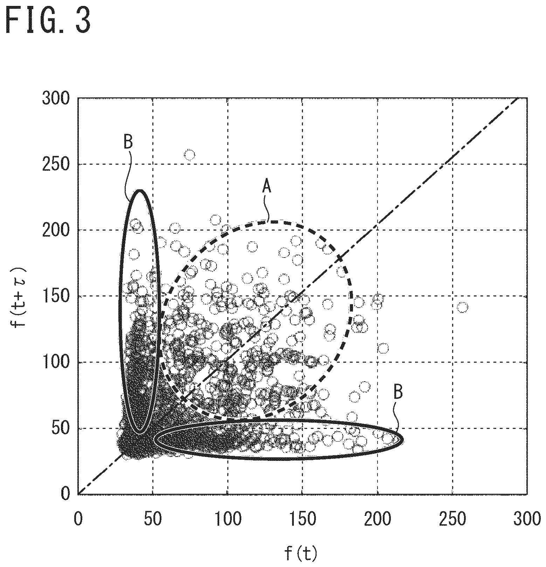

In terms of a waveform f(t) illustrated in FIG. 2, a correlation diagram in which each data in the waveform f(t) is taken in the horizontal axis and each data in a measured waveform f(t-τ) shifted by one period is taken in the vertical axis is illustrated like FIG. 3.

Here, disturbance noise such as magnetostrictive noise is noise strictly synchronous with the powerline period (powerline-period synchronous noise). From this point, signals of the disturbance noise are placed at positions approaching the straight line at 45 degrees as indicated by a reference sign A in FIG. 3. In the meantime, signals derived from partial discharge are generated with fluctuations with respect to the powerline period. Accordingly, as indicated by a reference sign B in FIG. 3, the signals derived from partial discharge are placed at positions deviating from the straight line at 45 degrees toward both sides across the straight line. Note that the position of the straight line at 45 degrees is placed at a position where the difference in amplitude between the measured waveform and the measured waveform shifted by one period is zero. As a position deviates from the straight line at 45 degrees, the difference in amplitude becomes larger.

Thus, as for the measured waveform, it is found that, in data of a differential waveform, the powerline-period synchronous noise gathers near the position where the amplitude is zero, and the signals derived from partial discharge are present at positions with a predetermined amplitude or more. Here, the data of the differential waveform is data obtained by taking the difference in amplitude between an original waveform and a waveform shifted by one period.

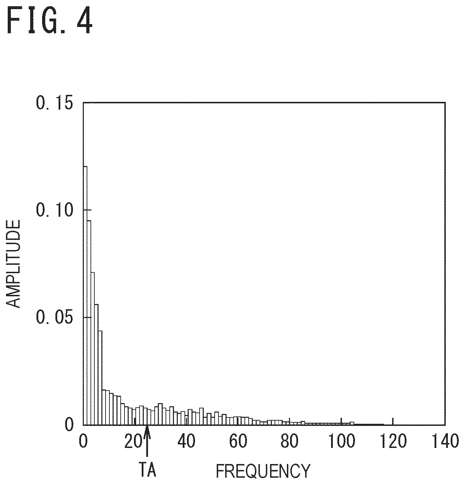

That is, the frequency distribution of the absolute values of amplitudes in the differential waveform is obtained as illustrated in FIG. 4. In FIG. 4, the horizontal axis indicates the absolute value of amplitude, and the vertical axis indicates frequency.

As can be understood from the above description, it is estimated that, in the distribution of FIG. 4, data near zero is data of the powerline-period synchronous noise, and data equal to or more than a predetermined amplitude is signals derived from partial discharge. The predetermined amplitude corresponds to the amplitude threshold TA in the present embodiment.

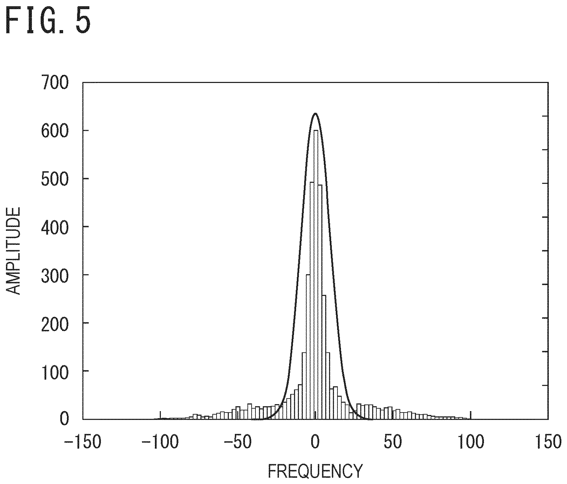

Note that the frequency distribution of amplitude data of the differential waveform is illustrated in FIG. **5****.** In the present embodiment, to find the amplitude threshold TA, it is assumed that, based on FIG. 4, disturbance noise components in the frequency distribution of the differential waveform can be approximated to a steep normal distribution. In the data of the differential waveform, the distribution near zero is regarded as a normal distribution. Further, by use of the standard deviation σ of the normal distribution and the set scale factor X, the amplitude threshold TA is found.

In the present embodiment, the scale factor X is set to 3, for example. In this case, in the data of the differential waveform, an amplitude equivalent to 3σ when the distribution near zero is regarded as the normal distribution is set as the amplitude threshold TA (absolute value).

In terms of the waveform f(t) before the difference is taken, in time t that satisfies a condition that f(t) - f (t+τ) is equal to or more than the amplitude threshold TA and f (t) - f(t-τ) is equal to or more than the amplitude threshold TA, partial discharge is determined to be observed, and data is extracted as a partial discharge signal. Hereby, in the present embodiment, it is possible to obtain the partial discharge signal from which the disturbance noise component is largely removed.

Hereby, in the present embodiment, it is possible to extract a partial-discharge derived signal accurately in comparison with the conventional technique.

Further, in the present embodiment, the occurrence state of partial discharge of the electrical equipment 1 is monitored based on the partial-discharge derived signal thus extracted accurately. As a result, it is found that the accuracy of the monitoring improves.

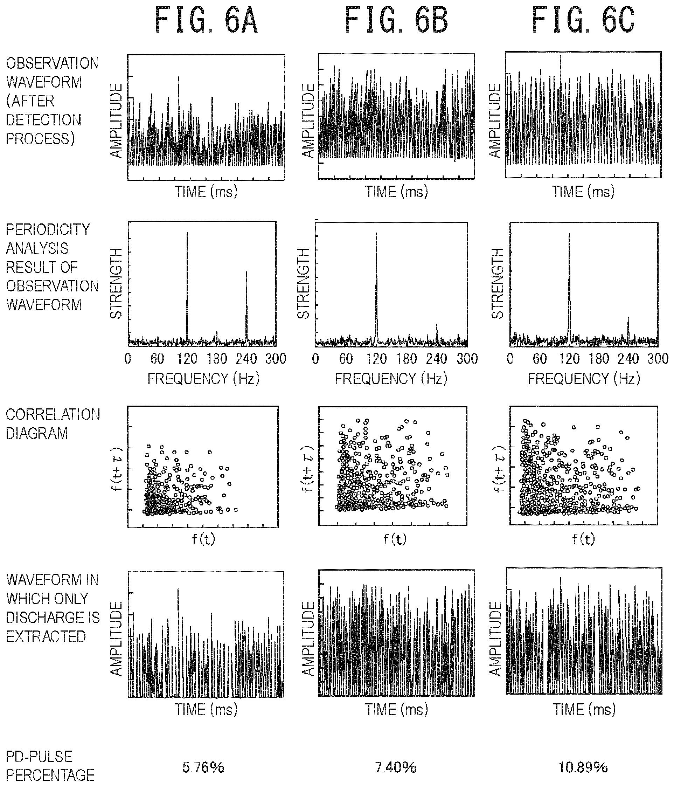

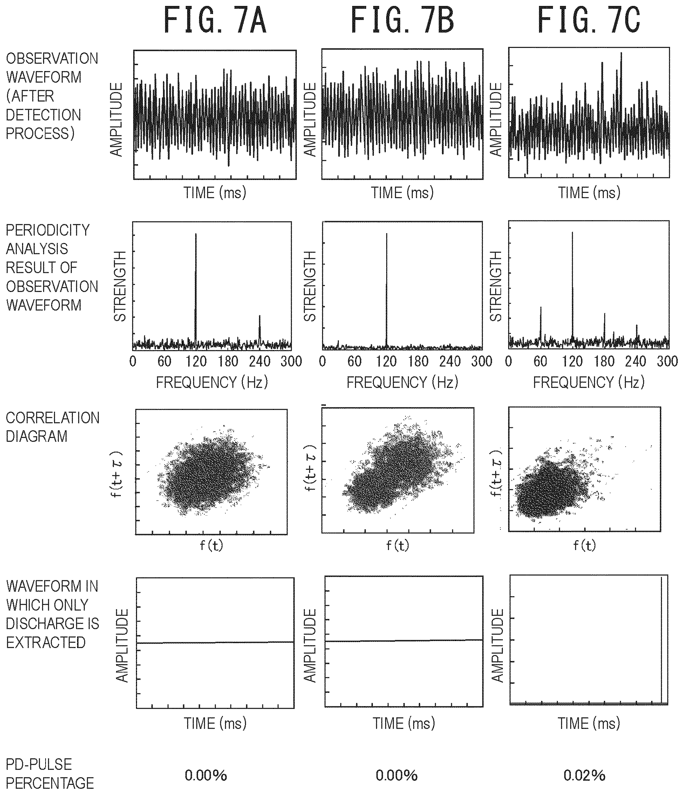

FIGS. 6 and 7 each illustrate a case where an observation waveform after the detection process, a periodicity analysis result on the observation waveform, a correlation diagram of the observation waveform, a waveform (a waveform of extracted partial discharge signals) in which only discharge is extracted, and a PD-pulse percentage as an evaluation example are found. FIG. 6 is an example in a case where a predetermined number or more of partial discharge occurs. FIG. 7 is an example in a case where the occurrence of partial discharge is small.

As illustrated in FIG. 6 (in the case where the predetermined number or more of partial discharge occurs) and FIG. 7 (in the case where the occurrence of partial discharge is small), the result of periodicity analysis (a conventional method of finding power supply periodicity in an observation waveform) exhibits that the observation waveform has the periodicity of an integral multiple of the power supply frequency (60 Hz). Accordingly, it is found that, even in a case where it is difficult to determine whether or not partial discharge occurs, it is possible to determine whether or not partial discharge occurs, by use of the PD-pulse percentage. Thus, it is found that, by use of the PD-pulse percentage, it is possible to monitor the occurrence state of partial discharge in the electrical equipment 1 under inspection with accuracy.

### (Effects)

The present embodiment yields the following effects, for example.
(1) A partial discharge monitoring method of the present embodiment includes: detecting , as an electrical signal, a physical quantity to be caused when partial discharge occurs in electrical equipment under inspection; extracting, as a detection processing signal, a change over time in the amplitude of a signal waveform to be caused by the partial discharge from the electrical signal thus detected; extracting a partial discharge signal derived from the partial discharge from the electrical signal or the detection processing signal by determining, in terms of the detection processing signal thus extracted, whether a signal measured in each time is the partial discharge signal or not, based on the signal thus measured in the each time and a signal shifted from the each time by m periods (m: an integer equal to or more than 1) of a power supply frequency of the electrical equipment; and evaluating the occurrence state of the partial discharge in the electrical equipment under inspection based on the partial discharge signal thus extracted.

For example, the partial discharge monitoring device 10 of the present embodiment includes: a sensor unit configured to detect , as an electrical signal, a physical quantity to be caused when partial discharge occurs in electrical equipment under inspection; a detection processing unit configured to perform a process of extracting, as a detection processing signal, a change over time in the amplitude of a signal waveform to be caused by the partial discharge from the electrical signal detected by the sensor unit; a partial discharge signal extraction unit configured to extract a partial discharge signal derived from the partial discharge from the electrical signal or the detection processing signal by determining, in terms of the detection processing signal processed by the detection processing unit, whether a signal measured in each time is the partial discharge signal or not, based on the signal thus measured in the each time and a signal shifted from the each time by m periods (m: an integer equal to or more than 1) of a power supply frequency of the electrical equipment; and a partial discharge evaluation unit configured to evaluate the occurrence state of the partial discharge in the electrical equipment under inspection based on the partial discharge signal extracted by the partial discharge signal extraction unit.

With this configuration, it is possible to extract data of partial discharge largely accurately by separating a disturbance noise component from a measured waveform. As a result, in the present embodiment, it is possible to accurately detect a partial discharge signal that is easily mistaken for disturbance noise such as magnetostrictive noise to be caused in sync with a power supply. Accordingly, it is possible to monitor the occurrence state of partial discharge in real time.

In the above embodiment, the determination on whether or not partial discharge occurs is performed based on the difference in amplitude between a signal measured in time targeted for the determination and a signal shifted from the time by m periods (m: an integer equal to or more than 1) of the power supply frequency of the electrical equipment.

For example, the partial discharge signal extraction unit includes: a differential waveform calculation unit configured to calculate a differential waveform for the detection processing signal processed by the detection processing unit, the differential waveform being constituted by the difference in amplitude between the detection processing signal and a signal obtained by shifting the detection processing signal by m periods (m: an integer equal to or more than 1) of the power supply frequency of the electrical equipment; an amplitude threshold setting unit configured to set an amplitude threshold based on the differential waveform calculated by the differential waveform calculation unit, the amplitude threshold being an amplitude based on which a disturbance noise signal with a small amplitude in the differential waveform is separated from the partial discharge signal with an amplitude larger than that of the disturbance noise signal in the differential waveform; and a main signal extraction unit configured to extract time in which the amplitude exceeds the amplitude threshold in the differential waveform calculated by the differential waveform calculation unit and to extract, as the partial discharge signal, a signal corresponding to the time thus extracted, from the electrical signal detected by the sensor unit or the detection processing signal processed by the detection processing unit.

(2) The amplitude threshold setting unit regards, as a normal distribution, a distribution near zero in an amplitude distribution of data of the differential waveform calculated by the differential waveform calculation unit, and sets the amplitude threshold based on the standard deviation σ of the normal distribution.

With this configuration, it is possible to separate noise components more accurately.

(3) The amplitude threshold setting unit sets, as the amplitude threshold, a value obtained by multiplying the standard deviation σ by a scale factor X selected from a range equal to or more than 2 but equal to or less than 4, for example.

With this configuration, it is possible to extract a more accurate partial discharge signal.

Note that, even in a case where the scale factor X is out of the range equal to or more than 2 but equal to or less than 4, it is possible to extract the partial discharge signal more accurately in comparison with the conventional technique.

(4) The physical quantity is, for example, a TEV (transient earth voltage) change, a current, an electromagnetic wave, or an ultrasonic wave to be caused by partial discharge from the electrical equipment 1 under inspection. That is, the sensor unit 10A is, for example, a TEV sensor configured to detect a TEV (transient earth voltage) change to be caused by partial discharge from the electrical equipment 1 under inspection, an HFCT sensor configured to detect a current to be caused by partial discharge from the electrical equipment 1 under inspection, an electromagnetic wave sensor configured to detect an electromagnetic wave, or an ultrasonic sensor configured to detect an ultrasonic wave to be caused by partial discharge from the electrical equipment 1 under inspection.

With this configuration, it is possible to surely detect, as an electrical signal, a physical quantity to be caused when partial discharge occurs in the electrical equipment 1 under inspection.

### (Modifications)

### <Modification 1>

In the above description, the amplitude threshold TA is a value determined based on the scale factor X set in advance and the standard deviation σ of the normal distribution, but the present invention is not limited to this.

For example, in the frequency distribution of absolute values of data in FIG. 4, an amplitude value at which the steepness of the gradient of the distribution is estimated to be relieved may be simply set as the amplitude threshold TA.

### <Modification 2>

Further, the partial discharge signal may be extracted as follows.

In the above embodiment, a differential waveform is found, and an amplitude distribution near zero in the differential waveform is assumed as a normal distribution. Based on the normal distribution, the standard deviation σ and the amplitude threshold TA are determined, and the partial discharge signal is extracted.

In the meantime, in Modification 2, the partial discharge signal is extracted as follows.

That is, the extraction of the partial discharge signal is performed such that, for the detection processing signal, a differential waveform constituted by the difference in amplitude between the detection processing signal and a signal obtained by shifting the detection processing signal by m periods (m: an integer equal to or more than 1) of the power supply frequency of the electrical equipment is calculated. Based on the differential waveform thus calculated, an amplitude threshold is set, the amplitude threshold being an amplitude based on which a disturbance noise signal with a small amplitude in the differential waveform is separated from a partial discharge signal with an amplitude larger than that of the disturbance noise signal in the differential waveform. Time in which the amplitude exceeds the amplitude threshold in the differential waveform thus calculated is extracted, and as the partial discharge signal, a signal corresponding to the time thus extracted is extracted from the electrical signal detected or the detection processing signal.

According to the invention, as an alternative, the detection processing signal processed by the detection processing unit, the partial discharge signal extraction unit 10C finds data or a function expressing a scatter diagram of an signal amplitude measured in each time and a signal amplitude shifted from the each time by m periods (m: an integer equal to or more than 1) of the power supply frequency of the electrical equipment. When a signal in time targeted for the determination is determined to fall within a region determined in advance in the scatter diagram based on the data or the function expressing the scatter diagram, the signal is determined as the partial discharge signal.

At this time, the predetermined region is set such that, for example, the frequency distribution of the detection processing signal processed by the detection processing unit 10B is calculated, and a frequency distribution in an amplitude range equal to or less than an amplitude µ with a maximum frequency is approximated to a normal distribution. Then, an amplitude threshold is set based on the standard deviation σ of the normal distribution. A region where a signal amplitude measured in each time is equal to or more than the amplitude threshold and a signal amplitude shifted by m periods is less than the amplitude threshold, and a region where a signal amplitude measured in each time is less than the amplitude threshold and a signal shifted by m periods is equal to or more than the amplitude threshold are defined.

For example, when a combination (a(t), b(t)) of a signal amplitude a(t) measured in each time and a signal amplitude b(t) (= a(t+τ)) shifted by m periods is determined to satisfy a predetermined condition determined in advance, a signal in the each time is determined as the partial discharge signal. For example, the predetermined condition determined in advance is set as follows: the frequency distribution of the detection processing signal processed by the detection processing unit is calculated, and a frequency distribution in an amplitude range equal to or less than the amplitude µ with the maximum frequency is approximated to a normal distribution. Then, an amplitude threshold is set based on the standard deviation of the normal distribution. Then, the predetermined condition is defined as a combination in which the signal amplitude a(t) measured in the each time is equal to or more than the amplitude threshold and the signal amplitude b(t) shifted by m periods is less than the amplitude threshold and as a combination in which the signal amplitude a(t) measured in the each time is less than the amplitude threshold and the signal amplitude b(t) shifted by m periods is equal to or more than the amplitude threshold.

Further, for example, the amplitude threshold is set to a value obtained by adding, to the amplitude µ with the maximum frequency, a value obtained by multiplying the standard deviation σ by a scale factor selected from the range equal to or more than 2 but equal to or less than 4.

That is, in Modification 2, the following process is executed.

First, a physical quantity to be caused when partial discharge occurs in the electrical equipment 1 under inspection is detected as an electrical signal, a low-frequency component is removed from the electrical signal thus detected by a high pass filter, and after that, the detection process is performed to extract a detected waveform.

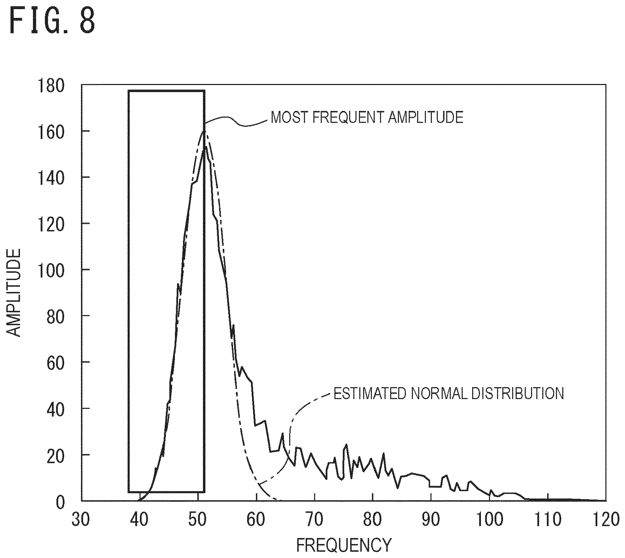

Subsequently, the amplitude distribution of the detected waveform is found, and the amplitude distribution of amplitudes lower than a most frequent amplitude is regarded as one side of a normal distribution and is approximated (see FIG. 8).

Subsequently, based on the approximate normal distribution thus obtained, an amplitude calculated by a setting method (µ + nσ) set in advance is set as an amplitude threshold.

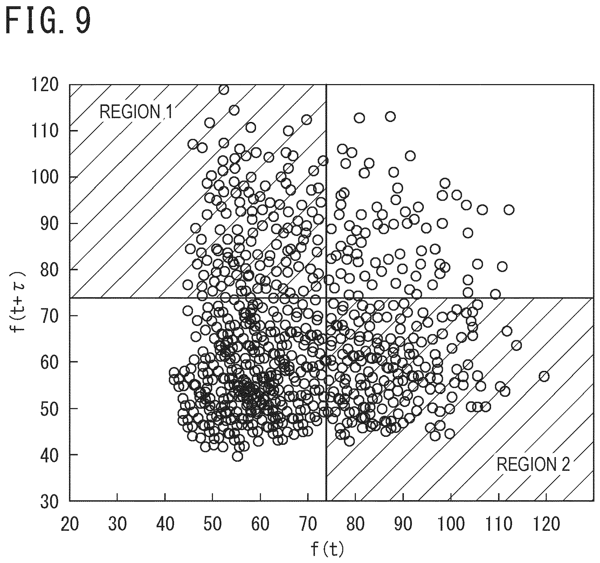

Then, a signal obtained after the detection process and a signal delayed by one period of the power supply frequency are considered in terms of a scatter diagram like FIG. 9. In this case, a point (data) included in either of the following regions is extracted as a partial discharge signal included in an original waveform: a region 2 in which the original waveform is equal to or more than the amplitude threshold, and a waveform shifted by one period is equal to or less than the amplitude threshold; and a region 1 in which the original waveform is equal to or less than the amplitude threshold, and a waveform shifted by one period is equal to or more than the amplitude threshold. The region 1 and the region 2 are regions indicated by hatching in FIG. 9.

The partial discharge signal extracted in Modification 2 has a higher percentage with which each partial discharge signal is determined as disturbance noise mistakenly, than the partial discharge signal extracted in the embodiment. However, main disturbance noise is removed from the partial discharge signal extracted in Modification 2 and can be also extracted with accuracy in comparison with the conventional technique.

Here, Japanese Patent Application No. 2020-150801 (filed on September 08, 2020) to which the present application claims priority, is mentioned. Herein, the present invention has been described by referring to a limited number of embodiments, but the scope of the present invention is not limited to them, and it is obvious for a person skilled in the art that the embodiments are modifiable based on the disclosure. The scope of the invention is defined by the claims.

### Reference Signs List

- 1: electrical equipment
- 10: partial discharge monitoring device
- 10A: sensor unit
- 10B: detection processing unit
- 10C: partial discharge signal extraction unit
- 10CA: differential waveform calculation unit
- 10CB: amplitude threshold setting unit
- 10CC: main signal extraction unit
- 10D: partial discharge evaluation unit
- TA: amplitude threshold
- X: scale factor

## Claims

1. A partial discharge monitoring device (10) comprising:
a sensor unit (10A) configured to detect, as an electrical signal, a physical quantity to be caused when partial discharge occurs in electrical equipment under inspection;
a detection processing unit (10B) configured to execute a process of extracting, as a detection processing signal, a change over time in an amplitude of a signal waveform to be caused by the partial discharge from the electrical signal detected by the sensor unit (10A);
a partial discharge signal extraction unit (10C) configured to extract a partial discharge signal derived from the partial discharge from the electrical signal or the detection processing signal by determining, in terms of the detection processing signal processed by the detection processing unit (10B), whether a signal measured in each time is the partial discharge signal or not, based on the signal thus measured in the each time and a signal shifted from the each time by m periods of a power supply frequency of the electrical equipment, where m is an integer equal to or more than 1; and
a partial discharge evaluation unit (10D) configured to evaluate an occurrence state of the partial discharge in the electrical equipment under inspection based on the partial discharge signal extracted by the partial discharge signal extraction unit (10C),
wherein the partial discharge signal extraction unit (10C) includes:
a differential waveform calculation unit (10CA) configured to calculate, in terms of the detection processing signal processed by the detection processing unit (10B), a differential waveform constituted by a difference in amplitude between the detection processing signal and a signal obtained by shifting the detection processing signal by m periods of the power supply frequency of the electrical equipment, where m is an integer equal to or more than 1;
an amplitude threshold setting unit (10CB) configured to set an amplitude threshold based on the differential waveform calculated by the differential waveform calculation unit (10CA), the amplitude threshold being an amplitude based on which a disturbance noise signal with a small amplitude in the differential waveform is separated from the partial discharge signal with an amplitude larger than that of the disturbance noise signal in the differential waveform; and
a main signal extraction unit (10CC) configured to extract time in which an amplitude exceeds the amplitude threshold in the differential waveform calculated by the differential waveform calculation unit (10CA) and to extract, as the partial discharge signal, a signal corresponding to the time thus extracted, from the electrical signal detected by the sensor unit (10A) or the detection processing signal processed by the detection processing unit (10B).

2. The partial discharge monitoring device (10) according to claim 1, wherein the amplitude threshold setting unit (10CB) is configured to regard, as a normal distribution, a distribution near zero in an amplitude distribution of the differential waveform calculated by the differential waveform calculation unit (10CA) and configured to set the amplitude threshold based on a standard deviation of the normal distribution.

3. The partial discharge monitoring device (10) according to claim 2, wherein the amplitude threshold setting unit (10CB) is configured to set, as the amplitude threshold, a value obtained by multiplying the standard deviation by a scale factor selected from a range equal to or more than 2 but equal to or less than 4.

4. A partial discharge monitoring device (10) comprising:
a sensor unit (10A) configured to detect, as an electrical signal, a physical quantity to be caused when partial discharge occurs in electrical equipment under inspection;
a detection processing unit (10B) configured to execute a process of extracting, as a detection processing signal, a change over time in an amplitude of a signal waveform to be caused by the partial discharge from the electrical signal detected by the sensor unit (10A);
a partial discharge signal extraction unit (10C) configured to extract a partial discharge signal derived from the partial discharge from the electrical signal or the detection processing signal by determining, in terms of the detection processing signal processed by the detection processing unit (10B), whether a signal measured in each time is the partial discharge signal or not, based on the signal thus measured in the each time and a signal shifted from the each time by m periods of a power supply frequency of the electrical equipment, where m is an integer equal to or more than 1; and
a partial discharge evaluation unit (10D) configured to evaluate an occurrence state of the partial discharge in the electrical equipment under inspection based on the partial discharge signal extracted by the partial discharge signal extraction unit (10C),
wherein the partial discharge signal extraction unit (10C) is configured to find, for the detection processing signal processed by the detection processing unit (10B), data or a function expressing a scatter diagram of a signal amplitude measured in each time and a signal amplitude shifted from the each time by m periods of the power supply frequency of the electrical equipment, where m is an integer equal to or more than 1; and
when the partial discharge signal extraction unit (10C) determines, based on the data or the function expressing the scatter diagram, that a signal amplitude in time targeted for the determination falls within a region determined in advance in the scatter diagram, the partial discharge signal extraction unit (10C) is configured to determine that the signal corresponding to the time is the partial discharge signal.

5. The partial discharge monitoring device (10) according to claim 4, wherein the region determined in advance is defined as the following regions:
a region where a signal amplitude measured in each time is equal to or more than an amplitude threshold and a signal amplitude shifted by m periods is less than the amplitude threshold, the amplitude threshold being set based on a standard deviation of a normal distribution to which a frequency distribution within an amplitude range equal to or less than an amplitude µ having a maximum frequency is approximated, the frequency distribution being included in a frequency distribution calculated as a frequency distribution of the detection processing signal processed by the detection processing unit (10B); and
a region where the signal amplitude measured in the each time is less than the amplitude threshold and a signal shifted by m periods is equal to or more than the amplitude threshold.

6. The partial discharge monitoring device (10) according to claim 5, wherein the amplitude threshold is set to a value obtained by adding, to the amplitude µ having the maximum frequency, a value obtained by multiplying the standard deviation by a scale factor selected from a range equal to or more than 2 but equal to or less than 4.

7. The partial discharge monitoring device (10) according to any one of claims 1 to 6, wherein the sensor unit (10A) is any of the following sensors:
a transient earth voltage, TEV, sensor configured to detect a TEV change generated from the electrical equipment under inspection;
a high-frequency CT sensor configured to measure a current pulse flowing to an earthing conductor;
an electromagnetic wave sensor configured to detect an electromagnetic wave to be caused along with partial discharge; and
an ultrasonic sensor configured to detect an ultrasonic wave generated from the electrical equipment under inspection.

8. A partial discharge monitoring method comprising:
detecting, as an electrical signal, a physical quantity to be caused when partial discharge occurs in electrical equipment under inspection;
extracting, as a detection processing signal, a change over time in an amplitude of a signal waveform to be caused by partial discharge from the electrical signal thus detected;
extracting a partial discharge signal derived from the partial discharge from the electrical signal or the detection processing signal by determining, in terms of the detection processing signal thus extracted, whether or not a signal measured in each time is the partial discharge signal, based on the signal thus measured in the each time and a signal shifted from the each time by m periods (m: an integer equal to or more than 1) of a power supply frequency of the electrical equipment; and
evaluating an occurrence state of the partial discharge in the electrical equipment under inspection based on the partial discharge signal thus extracted,
wherein:
the determination on whether or not the partial discharge occurs is performed based on a difference in amplitude between the signal measured in the each time and the signal shifted from the each time by m periods of the power supply frequency of the electrical equipment, where m is an integer equal to or more than 1; and
the extraction of the partial discharge signal includes:
calculating, for the detection processing signal, a differential waveform constituted by a difference in amplitude between the detection processing signal and a signal obtained by shifting the detection processing signal by m periods of the power supply frequency of the electrical equipment, where m is an integer equal to or more than 1;
setting an amplitude threshold based on the differential waveform thus calculated, the amplitude threshold being an amplitude based on which a disturbance noise signal with a small amplitude in the differential waveform is separated from the partial discharge signal with an amplitude larger than that of the disturbance noise signal in the differential waveform;
extracting time at which an amplitude exceeds the amplitude threshold in the differential waveform thus calculated; and
extracting, as the partial discharge signal, a signal corresponding to the time thus extracted from the electrical signal or the detection processing signal.

9. A partial discharge monitoring method comprising:
detecting, as an electrical signal, a physical quantity to be caused when partial discharge occurs in electrical equipment under inspection;
extracting, as a detection processing signal, a change over time in an amplitude of a signal waveform to be caused by partial discharge from the electrical signal thus detected;
extracting a partial discharge signal derived from the partial discharge from the electrical signal or the detection processing signal by determining, in terms of the detection processing signal thus extracted, whether or not a signal measured in each time is the partial discharge signal, based on the signal thus measured in the each time and a signal shifted from the each time by m periods of a power supply frequency of the electrical equipment, where m: an integer equal to or more than 1; and
evaluating an occurrence state of the partial discharge in the electrical equipment under inspection based on the partial discharge signal thus extracted,
wherein the determination is performed such that:
data or a function expressing a scatter diagram of a signal amplitude measured in each time and a signal amplitude shifted from the each time by m periods of the power supply frequency of the electrical equipment is found for the detection processing signal, where m is an integer equal to or more than 1; and
when, based on the data or the function expressing the scatter diagram, a signal amplitude in time targeted for the determination falls within a region determined in advance in the scatter diagram, a signal corresponding to the time is determined as the partial discharge signal.

10. The partial discharge monitoring method according to claim 9, wherein the region determined in advance is set to the following regions:
a region where a signal amplitude measured in each time is equal to or more than an amplitude threshold and a signal amplitude shifted by m periods is less than the amplitude threshold, the amplitude threshold being set based on a standard deviation of a normal distribution to which a frequency distribution within an amplitude range equal to or less than an amplitude µ having a maximum frequency is approximated, the frequency distribution being included in a frequency distribution calculated as a frequency distribution of the detection processing signal; and
a region where the signal amplitude measured in the each time is less than the amplitude threshold and a signal shifted by m periods is equal to or more than the amplitude threshold.

## Patentansprüche

1. Teilentladungsüberwachungsvorrichtung (10), umfassend:
eine Sensoreinheit (10A), die dazu konfiguriert ist, eine physikalische Größe, die zu verursachen ist, wenn eine Teilentladung in einem zu untersuchenden elektrischen Gerät auftritt, als ein elektrisches Signal zu erfassen;
eine Erfassungsverarbeitungseinheit (10B), die dazu konfiguriert ist, einen Prozess zum Extrahieren einer Änderung einer Amplitude einer Signalwellenform im Zeitverlauf, die durch die Teilentladung zu verursachen ist, aus dem durch die Sensoreinheit (10A) erfassten elektrischen Signal als ein Erfassungsverarbeitungssignal auszuführen;
eine Teilentladungssignal-Extraktionseinheit (10C), die dazu konfiguriert ist, ein Teilentladungssignal, das von der Teilentladung abgeleitet ist, aus dem elektrischen Signal oder dem Erfassungsverarbeitungssignal zu extrahieren, indem im Hinblick auf das durch die Erfassungsverarbeitungseinheit (10B) verarbeitete Erfassungsverarbeitungssignal bestimmt wird, ob ein Signal, das zu jeder Zeit gemessen wird, das Teilentladungssignal ist oder nicht, auf Grundlage des Signals, das so zu jeder Zeit gemessen wird, und eines Signals, das von jeder Zeit um m Perioden einer Leistungsversorgungsfrequenz des elektrischen Geräts verschoben ist, wobei m eine ganze Zahl gleich oder größer als 1 ist; und
eine Teilentladungs-Bewertungseinheit (10D), die dazu konfiguriert ist, einen Zustand eines Auftretens der Teilentladung in dem zu untersuchenden elektrischen Gerät auf Grundlage des durch die Teilentladungssignal-Extraktionseinheit (10C) extrahierten Teilentladungssignals zu bewerten,
wobei die Teilentladungssignal-Extraktionseinheit (10C) Folgendes beinhaltet:
eine Differenzwellenform-Berechnungseinheit (10CA), die dazu konfiguriert ist, im Hinblick auf das durch die Erfassungsverarbeitungseinheit (10B) verarbeitete Erfassungsverarbeitungssignal eine Differenzwellenform zu berechnen, die durch eine Amplitudendifferenz zwischen dem Erfassungsverarbeitungssignal und einem Signal dargestellt ist, das durch Verschieben des Erfassungsverarbeitungssignals um m Perioden der Leistungsversorgungsfrequenz des elektrischen Geräts erlangt wird, wobei m eine ganze Zahl gleich oder größer als 1 ist;
eine Amplitudenschwellenwert-Festlegungseinheit (10CB), die dazu konfiguriert ist, einen Amplitudenschwellenwert auf Grundlage der durch die Differenzwellenform-Berechnungseinheit (10CA) berechneten Differenzwellenform festzulegen, wobei der Amplitudenschwellenwert eine Amplitude ist, auf deren Grundlage ein Störrauschsignal mit einer kleinen Amplitude in der Differenzwellenform von dem Teilentladungssignal mit einer Amplitude, die größer als die des Störrauschsignals in der Differenzwellenform ist, getrennt wird; und
eine Haupt-Signalextraktionseinheit (10CC), die dazu konfiguriert ist, Zeit zu extrahieren, in der eine Amplitude den Amplitudenschwellenwert in der durch die Differenzsignal-Berechnungseinheit (10CA) berechneten Differenzwellenform überschreitet, und ein Signal, das der so extrahierten Zeit entspricht, aus dem durch die Sensoreinheit (10A) erfassten elektrischen Signal oder dem durch die Erfassungsverarbeitungseinheit (10B) verarbeiteten Erfassungsverarbeitungssignal als das Teilentladungssignal zu extrahieren.

2. Teilentladungsüberwachungsvorrichtung (10) nach Anspruch 1, wobei die Amplitudenschwellenwert-Festlegungseinheit (10CB) dazu konfiguriert ist, eine Verteilung nahe Null in einer Amplitudenverteilung der durch die Differenzwellenform-Berechnungseinheit (10CA) berechneten Differenzwellenform als eine Normalverteilung zu betrachten, und dazu konfiguriert ist, den Amplitudenschwellenwert auf Grundlage einer Standardabweichung der Normalverteilung festzulegen.

3. Teilentladungsüberwachungsvorrichtung (10) nach Anspruch 2, wobei die Amplitudenschwellenwert-Festlegungseinheit (10CB) dazu konfiguriert ist, einen Wert, der durch Multiplizieren der Standardabweichung mit einem Skalenfaktor, der aus einem Bereich ausgewählt ist, der gleich oder größer als 2, aber gleich oder kleiner als 4 ist, erlangt wird, als den Amplitudenschwellenwert festzulegen.

4. Teilentladungsüberwachungsvorrichtung (10), umfassend:
eine Sensoreinheit (10A), die dazu konfiguriert ist, eine physikalische Größe, die zu verursachen ist, wenn eine Teilentladung in einem zu untersuchenden elektrischen Gerät auftritt, als ein elektrisches Signal zu erfassen;
eine Erfassungsverarbeitungseinheit (10B), die dazu konfiguriert ist, einen Prozess zum Extrahieren einer Änderung einer Amplitude einer Signalwellenform im Zeitverlauf, die durch die Teilentladung zu verursachen ist, aus dem durch die Sensoreinheit (10A) erfassten elektrischen Signal als ein Erfassungsverarbeitungssignal auszuführen;
eine Teilentladungssignal-Extraktionseinheit (10C), die dazu konfiguriert ist, ein Teilentladungssignal, das von der Teilentladung abgeleitet ist, aus dem elektrischen Signal oder dem Erfassungsverarbeitungssignal zu extrahieren, indem im Hinblick auf das durch die Erfassungsverarbeitungseinheit (10B) verarbeitete Erfassungsverarbeitungssignal bestimmt wird, ob ein Signal, das zu jeder Zeit gemessen wird, das Teilentladungssignal ist oder nicht, auf Grundlage des Signals,
das so zu jeder Zeit gemessen wird, und eines Signals, das von jeder Zeit um m Perioden einer Leistungsversorgungsfrequenz des elektrischen Geräts verschoben ist, wobei m eine ganze Zahl gleich oder größer als 1 ist; und
eine Teilentladungs-Bewertungseinheit (10D), die dazu konfiguriert ist, einen Zustand eines Auftretens der Teilentladung in dem zu untersuchenden elektrischen Gerät auf Grundlage des durch die Teilentladungssignal-Extraktionseinheit (10C) extrahierten Teilentladungssignals zu bewerten,
wobei die Teilentladungssignal-Extraktionseinheit (10C) dazu konfiguriert ist, für das durch die Erfassungsverarbeitungseinheit (10B) verarbeitete Erfassungsverarbeitungssignal Daten oder eine Funktion zu finden, die ein Streudiagramm einer Signalamplitude, die zu jeder Zeit gemessen wird, und einer Signalamplitude, die von jeder Zeit um m Perioden der Leistungsversorgungsfrequenz des elektrischen Geräts verschoben ist, ausdrücken, wobei m eine ganze Zahl gleich oder größer als 1 ist; und
wenn die Teilentladungssignal-Extraktionseinheit (10C) auf Grundlage der Daten oder der Funktion, die das Streudiagramm ausdrücken, bestimmt, dass eine zeitlich für die Bestimmung anvisierte Signalamplitude innerhalb einer in dem Streudiagramm vorab bestimmten Region liegt, die Teilentladungssignal-Extraktionseinheit (10C) dazu konfiguriert ist, zu bestimmen, dass das der Zeit entsprechende Signal das Teilentladungssignal ist.

5. Teilentladungsüberwachungsvorrichtung (10) nach Anspruch 4, wobei die vorab bestimmte Region als die folgenden Regionen definiert ist:
eine Region, in der eine zu jeder Zeit gemessene Signalamplitude gleich einem Amplitudenschwellenwert oder größer als dieser ist und eine um m Perioden verschobene Signalamplitude kleiner als der Amplitudenschwellenwert ist, wobei der Amplitudenschwellenwert auf Grundlage einer Standardabweichung einer Normalverteilung, an die eine Frequenzverteilung innerhalb eines Amplitudenbereichs gleich einer Amplitude µ oder kleiner als diese mit einer Maximalfrequenz angenähert wird, festgelegt wird, wobei die Frequenzverteilung in einer Frequenzverteilung beinhaltet ist, die als eine Frequenzverteilung des durch die Erfassungsverarbeitungseinheit (10B) verarbeiteten Erfassungsverarbeitungssignals berechnet wird; und
eine Region, in der die zu jeder Zeit gemessene Signalamplitude kleiner als der Amplitudenschwellenwert ist und ein um m Perioden verschobenes Signal gleich dem Amplitudenschwellenwert oder größer als dieser ist.

6. Teilentladungsüberwachungsvorrichtung (10) nach Anspruch 5, wobei der Amplitudenschwellenwert auf einen Wert festgelegt ist, der durch Addieren eines Werts, der durch Multiplizieren der Standardabweichung mit einem Skalenfaktor, der aus einem Bereich ausgewählt ist, der gleich oder größer als 2, aber gleich oder kleiner als 4 ist, erlangt wird, zu der Amplitude µ mit der Maximalfrequenz erlangt wird.

7. Teilentladungsüberwachungsvorrichtung (10) nach einem der Ansprüche 1 bis 6, wobei die Sensoreinheit (10A) einer der folgenden Sensoren ist:
ein Sensor für transiente Erdspannung (transient earth voltage - TEV), der dazu konfiguriert ist, eine TEV-Änderung zu erfassen, die von dem zu untersuchenden elektrischen Gerät erzeugt wird;
ein Hochfrequenz-CT-Sensor, der dazu konfiguriert ist, einen Stromimpuls zu messen, der zu einem Erdungsleiter fließt;
ein Sensor für elektromagnetische Wellen, der dazu konfiguriert ist, eine elektromagnetische Welle zu erfassen, die zusammen mit einer Teilentladung zu verursachen ist; und
ein Ultraschallsensor, der dazu konfiguriert ist, eine Ultraschallwelle zu erfassen, die von dem zu untersuchenden elektrischen Gerät erzeugt wird.

8. Teilentladungsüberwachungsverfahren, umfassend:
Erfassen einer physikalischen Größe, die zu verursachen ist, wenn eine Teilentladung in einem zu untersuchenden elektrischen Gerät auftritt, als ein elektrisches Signal;
Extrahieren einer Änderung einer Amplitude einer Signalwellenform im Zeitverlauf, die durch die Teilentladung aus dem so erfassten elektrischen Signal zu verursachen ist, als ein Erfassungsverarbeitungssignal;
Extrahieren eines Teilentladungssignals, das von der Teilentladung abgeleitet ist, aus dem elektrischen Signal oder dem Erfassungsverarbeitungssignal, indem im Hinblick auf das so extrahierte Erfassungsverarbeitungssignal bestimmt wird, ob ein Signal, das zu jeder Zeit gemessen wird, das Teilentladungssignal ist oder nicht, auf Grundlage des Signals,
das so zu jeder Zeit gemessen wird, und eines Signals, das von jeder Zeit um m Perioden (m: eine ganze Zahl gleich oder größer als 1) einer Leistungsversorgungsfrequenz des elektrischen Geräts verschoben ist; und
Bewerten eines Zustands des Auftretens der Teilentladung in dem zu untersuchenden elektrischen Gerät auf Grundlage des so extrahierten Teilentladungssignals,
wobei:
die Bestimmung, ob die Teilentladung auftritt oder nicht, auf Grundlage einer Amplitudendifferenz zwischen dem zu jeder Zeit gemessenen Signal und dem von jeder Zeit um m Perioden der Leistungsversorgungsfrequenz des elektrischen Geräts verschobenen Signal durchgeführt wird, wobei m eine ganze Zahl gleich oder größer als 1 ist; und
die Extraktion des Teilentladungssignals Folgendes beinhaltet: Berechnen einer Differenzwellenform, die durch eine Amplitudendifferenz zwischen dem Erfassungsverarbeitungssignal und einem Signal, das durch Verschieben des Erfassungsverarbeitungssignals um m Perioden der Leistungsversorgungsfrequenz des elektrischen Geräts erlangt wird, dargestellt wird, für das Erfassungsverarbeitungssignal, wobei m eine ganze Zahl gleich oder größer als 1 ist;
Festlegen eines Amplitudenschwellenwerts auf Grundlage der so berechneten Differenzwellenform, wobei der Amplitudenschwellenwert eine Amplitude ist, auf deren Grundlage ein Störrauschsignal mit einer kleinen Amplitude in der Differenzwellenform von dem Teilentladungssignal mit einer Amplitude, die größer als die des Störrauschsignals in der Differenzwellenform ist, getrennt wird;
Extrahieren von Zeit, zu der eine Amplitude den Amplitudenschwellenwert in der so berechneten Differenzwellenform überschreitet; und
Extrahieren eines Signals, das der so aus dem elektrischen Signal oder dem Erfassungsverarbeitungssignal extrahierten Zeit entspricht, als das Teilentladungssignal.

9. Teilentladungsüberwachungsverfahren, umfassend:
Erfassen einer physikalischen Größe, die zu verursachen ist, wenn eine Teilentladung in einem zu untersuchenden elektrischen Gerät auftritt, als ein elektrisches Signal;
Extrahieren einer Änderung einer Amplitude einer Signalwellenform im Zeitverlauf, die durch die Teilentladung aus dem so erfassten elektrischen Signal zu verursachen ist, als ein Erfassungsverarbeitungssignal;
Extrahieren eines Teilentladungssignals, das von der Teilentladung abgeleitet ist, aus dem elektrischen Signal oder dem Erfassungsverarbeitungssignal, indem im Hinblick auf das so extrahierte Erfassungsverarbeitungssignal bestimmt wird, ob ein Signal, das zu jeder Zeit gemessen wird, das Teilentladungssignal ist oder nicht, auf Grundlage des Signals, das so zu jeder Zeit gemessen wird, und eines Signals, das von jeder Zeit um m Perioden einer Leistungsversorgungsfrequenz des elektrischen Geräts verschoben ist, wobei m: eine ganze Zahl gleich oder größer als 1 ist; und
Bewerten eines Zustands des Auftretens der Teilentladung in dem zu untersuchenden elektrischen Gerät auf Grundlage des so extrahierten Teilentladungssignals,
wobei die Bestimmung derart durchgeführt wird, dass:
Daten oder eine Funktion, die ein Streudiagramm einer Signalamplitude, die zu jeder Zeit gemessen wird, und einer Signalamplitude, die von jeder Zeit um m Perioden der Leistungsversorgungsfrequenz des elektrischen Geräts verschoben ist, ausdrücken, für das Erfassungsverarbeitungssignal gefunden werden, wobei m eine ganze Zahl gleich oder größer als 1 ist; und
wenn auf Grundlage der Daten oder der Funktion, die das Streudiagramm ausdrücken, eine zeitlich für die Bestimmung anvisierte Signalamplitude innerhalb einer in dem Streudiagramm vorab bestimmten Region liegt, ein der Zeit entsprechendes Signal als das Teilentladungssignal bestimmt wird.

10. Teilentladungsüberwachungsverfahren nach Anspruch 9, wobei die vorab bestimmte Region auf die folgenden Regionen festgelegt wird:
eine Region, in der eine zu jeder Zeit gemessene Signalamplitude gleich einem Amplitudenschwellenwert oder größer als dieser ist und eine um m Perioden verschobene Signalamplitude kleiner als der Amplitudenschwellenwert ist, wobei der Amplitudenschwellenwert auf Grundlage einer Standardabweichung einer Normalverteilung, an die eine Frequenzverteilung innerhalb eines Amplitudenbereichs gleich einer Amplitude µ oder kleiner als diese mit einer Maximalfrequenz angenähert wird, festgelegt wird, wobei die Frequenzverteilung in einer Frequenzverteilung beinhaltet ist, die als eine Frequenzverteilung des Erfassungsverarbeitungssignals berechnet wird; und
eine Region, in der die zu jeder Zeit gemessene Signalamplitude kleiner als der Amplitudenschwellenwert ist und ein um m Perioden verschobenes Signal gleich dem Amplitudenschwellenwert oder größer als dieser ist.

## Revendications

1. Dispositif de surveillance de décharge partielle (10) comprenant :
une unité de capteur (10A) configurée pour détecter, en tant que signal électrique, une quantité physique à provoquer lorsqu'une décharge partielle se produit dans un équipement électrique en cours d'inspection ;
une unité de traitement de détection (10B) configurée pour exécuter un processus d'extraction, en tant que signal de traitement de détection, d'un changement dans le temps d'une amplitude d'une forme d'onde de signal à provoquer par la décharge partielle du signal électrique détecté par l'unité de capteur (10A) ;
une unité d'extraction de signal de décharge partielle (10C) configurée pour extraire un signal de décharge partielle dérivé de la décharge partielle du signal électrique ou du signal de traitement de détection en déterminant, en ce qui concerne le signal de traitement de détection traité par l'unité de traitement de détection (10B), si un signal mesuré à chaque instant est le signal de décharge partielle ou non, sur la base du signal ainsi mesuré au chaque instant et d'un signal décalé du chaque instant de m périodes d'une fréquence d'alimentation de l'équipement électrique, où m est un entier égal ou supérieur à 1 ; et
une unité d'évaluation de décharge partielle (10D) configurée pour évaluer un état d'occurrence de la décharge partielle dans l'équipement électrique en cours d'inspection sur la base du signal de décharge partielle extrait par l'unité d'extraction de signal de décharge partielle (10C),
dans lequel l'unité d'extraction de signal de décharge partielle (10C) comporte :
une unité de calcul de forme d'onde différentielle (10CA) configurée pour calculer, en ce qui concerne le signal de traitement de détection traité par l'unité de traitement de détection (10B), une forme d'onde différentielle constituée par une différence d'amplitude entre le signal de traitement de détection et un signal obtenu en décalant le signal de traitement de détection de m périodes de la fréquence d'alimentation de l'équipement électrique, où m est un entier égal ou supérieur à 1 ;
une unité de réglage de seuil d'amplitude (10CB) configurée pour régler un seuil d'amplitude sur la base de la forme d'onde différentielle calculée par l'unité de calcul de forme d'onde différentielle (10CA), le seuil d'amplitude étant une amplitude sur la base de laquelle un signal de bruit perturbateur avec une petite amplitude dans la forme d'onde différentielle est séparé du signal de décharge partielle avec une amplitude supérieure à celle du signal de bruit perturbateur dans la forme d'onde différentielle ; et
une unité d'extraction de signal principale (10CC) configurée pour extraire le temps dans lequel une amplitude dépasse le seuil d'amplitude dans la forme d'onde différentielle calculée par l'unité de calcul de forme d'onde différentielle (10CA) et pour extraire, en tant que signal de décharge partielle, un signal correspondant au temps ainsi extrait, à partir du signal électrique détecté par l'unité de capteur (10A) ou du signal de traitement de détection traité par l'unité de traitement de détection (10B).

2. Dispositif de surveillance de décharge partielle (10) selon la revendication 1, dans lequel l'unité de réglage de seuil d'amplitude (10CB) est configurée pour considérer, en tant que distribution normale, une distribution proche de zéro dans une distribution d'amplitude de la forme d'onde différentielle calculée par l'unité de calcul de forme d'onde différentielle (10CA) et configurée pour régler le seuil d'amplitude sur la base d'un écart type de la distribution normale.

3. Dispositif de surveillance de décharge partielle (10) selon la revendication 2, dans lequel l'unité de réglage de seuil d'amplitude (10CB) est configurée pour régler, en tant que seuil d'amplitude, une valeur obtenue en multipliant l'écart type par un facteur d'échelle sélectionné dans une plage égale ou supérieure à 2 mais égale ou inférieure à 4.

4. Dispositif de surveillance de décharge partielle (10) comprenant :
une unité de capteur (10A) configurée pour détecter, en tant que signal électrique, une quantité physique à provoquer lorsqu'une décharge partielle se produit dans un équipement électrique en cours d'inspection ;
une unité de traitement de détection (10B) configurée pour exécuter un processus d'extraction, en tant que signal de traitement de détection, d'un changement dans le temps d'une amplitude d'une forme d'onde de signal à provoquer par la décharge partielle du signal électrique détecté par l'unité de capteur (10A) ;
une unité d'extraction de signal de décharge partielle (10C) configurée pour extraire un signal de décharge partielle dérivé de la décharge partielle du signal électrique ou du signal de traitement de détection en déterminant, en ce qui concerne le signal de traitement de détection traité par l'unité de traitement de détection (10B), si un signal mesuré à chaque instant est le signal de décharge partielle ou non, sur la base du signal ainsi mesuré au chaque instant et d'un signal décalé du chaque instant de m périodes d'une fréquence d'alimentation de l'équipement électrique, où m est un entier égal ou supérieur à 1 ; et
une unité d'évaluation de décharge partielle (10D) configurée pour évaluer un état d'occurrence de la décharge partielle dans l'équipement électrique en cours d'inspection sur la base du signal de décharge partielle extrait par l'unité d'extraction de signal de décharge partielle (10C),
dans lequel l'unité d'extraction de signal de décharge partielle (10C) est configurée pour trouver, pour le signal de traitement de détection traité par l'unité de traitement de détection (10B), des données ou une fonction exprimant un diagramme de dispersion d'une amplitude de signal mesurée à chaque instant et une amplitude de signal décalée du chaque instant de m périodes de la fréquence d'alimentation de l'équipement électrique, où m est un entier égal ou supérieur à 1 ; et
lorsque l'unité d'extraction de signal de décharge partielle (10C) détermine, sur la base des données ou de la fonction exprimant le diagramme de dispersion, qu'une amplitude de signal dans le temps ciblée pour la détermination tombe dans une région déterminée à l'avance dans le diagramme de dispersion, l'unité d'extraction de signal de décharge partielle (10C) est configurée pour déterminer que le signal correspondant au temps est le signal de décharge partielle.

5. Dispositif de surveillance de décharge partielle (10) selon la revendication 4, dans lequel la région déterminée à l'avance est définie comme les régions suivantes :
une région où une amplitude de signal mesurée à chaque instant est égale ou supérieure à un seuil d'amplitude et une amplitude de signal décalée de m périodes est inférieure au seuil d'amplitude, le seuil d'amplitude étant réglé sur la base d'un écart type d'une distribution normale à laquelle une distribution de fréquence dans une plage d'amplitude égale ou inférieure à une amplitude µ ayant une fréquence maximale est approximée, la distribution de fréquence étant incluse dans une distribution de fréquence calculée en tant que distribution de fréquence du signal de traitement de détection traité par l'unité de traitement de détection (10B) ; et
une région où l'amplitude de signal mesurée au chaque instant est inférieure au seuil d'amplitude et un signal décalé de m périodes est égal ou supérieur au seuil d'amplitude.

6. Dispositif de surveillance de décharge partielle (10) selon la revendication 5, dans lequel le seuil d'amplitude est réglé sur une valeur obtenue en ajoutant, à l'amplitude µ ayant la fréquence maximale, une valeur obtenue en multipliant l'écart type par un facteur d'échelle sélectionné dans une plage égale ou supérieure à 2 mais égale ou inférieure à 4.

7. Dispositif de surveillance de décharge partielle (10) selon l'une quelconque des revendications 1 à 6, dans lequel l'unité de capteur (10A) est l'un quelconque des capteurs suivants :
un capteur de tension de terre transitoire, TEV, configuré pour détecter un changement de TEV généré par l'équipement électrique en cours d'inspection ;
un capteur CT haute fréquence configuré pour mesurer une impulsion de courant circulant vers un conducteur de mise à la terre ;
un capteur d'ondes électromagnétiques configuré pour détecter une onde électromagnétique à provoquer avec une décharge partielle ; et
un capteur à ultrasons configuré pour détecter une onde ultrasonore générée par l'équipement électrique en cours d'inspection.

8. Procédé de surveillance de décharge partielle comprenant :
la détection, en tant que signal électrique, d'une quantité physique à provoquer lorsqu'une décharge partielle se produit dans un équipement électrique en cours d'inspection ;
l'extraction, en tant que signal de traitement de détection, d'un changement dans le temps d'une amplitude d'une forme d'onde de signal à provoquer par une décharge partielle du signal électrique ainsi détecté ;
l'extraction d'un signal de décharge partielle dérivé de la décharge partielle du signal électrique ou du signal de traitement de détection en déterminant, en ce qui concerne le signal de traitement de détection ainsi extrait, si un signal mesuré à chaque instant est le signal de décharge partielle ou non, sur la base du signal ainsi mesuré au chaque instant et d'un signal décalé du chaque instant de m périodes (m : un entier égal ou supérieur à 1) d'une fréquence d'alimentation de l'équipement électrique ; et
l'évaluation d'un état d'occurrence de la décharge partielle dans l'équipement électrique en cours d'inspection sur la base du signal de décharge partielle ainsi extrait,
dans lequel :
la détermination de la survenue ou non de la décharge partielle est effectuée sur la base d'une différence d'amplitude entre le signal mesuré au chaque instant et le signal décalé du chaque instant de m périodes de la fréquence d'alimentation de l'équipement électrique, où m est un entier égal ou supérieur à 1 ; et
l'extraction du signal de décharge partielle comporte :
le calcul, pour unité le signal de traitement de détection, d'une forme d'onde différentielle constituée par une différence d'amplitude entre le signal de traitement de détection et un signal obtenu en décalant le signal de traitement de détection de m périodes de la fréquence d'alimentation de l'équipement électrique, où m est un entier égal ou supérieur à 1 ;
le réglage d'un seuil d'amplitude sur la base de la forme d'onde différentielle ainsi calculée, le seuil d'amplitude étant une amplitude sur la base de laquelle un signal de bruit perturbateur avec une petite amplitude dans la forme d'onde différentielle est séparé du signal de décharge partielle avec une amplitude supérieure à celle du signal de bruit perturbateur dans la forme d'onde différentielle ;
l'extraction du temps auquel une amplitude dépasse le seuil d'amplitude dans la forme d'onde différentielle ainsi calculée ; et
l'extraction, en tant que signal de décharge partielle, d'un signal correspondant au temps ainsi extrait du signal électrique ou du signal de traitement de détection.

9. Procédé de surveillance de décharge partielle comprenant :
la détection, en tant que signal électrique, d'une quantité physique à provoquer lorsqu'une décharge partielle se produit dans un équipement électrique en cours d'inspection ;
l'extraction, en tant que signal de traitement de détection, d'un changement dans le temps d'une amplitude d'une forme d'onde de signal à provoquer par une décharge partielle du signal électrique ainsi détecté ;
l'extraction d'un signal de décharge partielle dérivé de la décharge partielle du signal électrique ou du signal de traitement de détection en déterminant, en ce qui concerne le signal de traitement de détection ainsi extrait, si un signal mesuré à chaque instant est le signal de décharge partielle ou non, sur la base du signal ainsi mesuré au chaque instant et d'un signal décalé du chaque instant de m périodes d'une fréquence d'alimentation de l'équipement électrique, où m : un entier égal ou supérieur à 1 ; et
l'évaluation d'un état d'occurrence de la décharge partielle dans l'équipement électrique en cours d'inspection sur la base du signal de décharge partielle ainsi extrait,
dans lequel la détermination est effectuée de sorte que :
des données ou une fonction exprimant un diagramme de dispersion d'une amplitude de signal mesurée à chaque instant et une amplitude de signal décalée du chaque instant de m périodes de la fréquence d'alimentation de l'équipement électrique sont trouvées pour le signal de traitement de détection, où m est un entier égal ou supérieur à 1 ; et
lorsque, sur la base des données ou de la fonction exprimant le diagramme de dispersion, une amplitude de signal dans le temps ciblée pour la détermination tombe dans une région déterminée à l'avance dans le diagramme de dispersion, un signal correspondant au temps est déterminé en tant que signal de décharge partielle.

10. Procédé de surveillance de décharge partielle selon la revendication 9, dans lequel la région déterminée à l'avance est réglée sur les régions suivantes :
une région où une amplitude de signal mesurée à chaque instant est égale ou supérieure à un seuil d'amplitude et une amplitude de signal décalée de m périodes est inférieure au seuil d'amplitude, le seuil d'amplitude étant réglé sur la base d'un écart type d'une distribution normale à laquelle une distribution de fréquence dans une plage d'amplitude égale ou inférieure à une amplitude µ ayant une fréquence maximale est approximée, la distribution de fréquence étant incluse dans une distribution de fréquence calculée en tant que distribution de fréquence du signal de traitement de détection ; et
une région où l'amplitude de signal mesurée au chaque instant est inférieure au seuil d'amplitude et un signal décalé de m périodes est égal ou supérieur au seuil d'amplitude.
